# EUROPEAN PATENT APPLICATION

(11) **EP 2 779 412 A1**
(43) Date of publication of application: **17.09.2014**
(21) Application number: 12848208.0
(22) Date of filing: 06.11.2012
(51) Int. Cl.: H02N 2/18, H01L 29/84, H01L 41/08, H01L 41/113, H01L 41/18, H01L 41/22, H01L 41/39

(54) **ENERGY HARVESTING DEVICE**

(30) Priority: 09.11.2011 JP 2011245508
(71) Applicant: Panasonic Corporation, Osaka 571-8501 (JP)
(72) Inventor: GOTO, Koji, Osaka 540-6207 (JP); YAMAUCHI, Norihiro, Osaka 540-6207 (JP); AIZAWA, Koichi, Osaka 540-6207 (JP); SAKAMOTO, Shinji, Osaka 540-6207 (JP); TSUJIMOTO, Toyohiko, Osaka 540-6207 (JP)
(74) Representative: Müller-Boré & Partner Patentanwälte PartG mbB
(86) International application number: PCT/JP2012/078737
(87) International publication number: WO 2013/069640

(57) **Abstract**

The energy harvesting device includes a power management circuit to charge a storage with power from a generator including generation units to generate AC power when vibrated. The power management circuit includes: a first power extraction circuit including a rectification circuit converting AC power at a first input unit into DC power; a second power extraction circuit including a switching circuit operating with power from the storage and generating DC power using AC power at a second input unit; and a switch circuit having a first connection mode of connecting the first input unit to the generation units to receive an AC voltage greater in effective value than an AC voltage to the second input unit, and a second connection mode of connecting the second input unit to the generation units to receive an AC voltage greater in effective value than an AC voltage to the first input unit.

## Description

### Technical Field

The present invention relates to energy harvesting devices.

### Background Art

Electric generators (piezoelectric vibration energy harvester) that convert vibration energy into electric energy using piezoelectric elements have attracted attention in the field of energy harvesting, and have been studied and developed in various organizations (see document 1[R. van Schaijk,et al, "Piezoelectric AlN energy harvesters for wireless autonomoustransducer solutions", IEEE SENSORS 2008 Conference,2008, p.45-48], and document 2 [S Roundy and P K Wright, "A piezoelectric vibration based generator for wireless electronics", Smart Materials and Structures 13,2004,p1131-1142]). Document 1 discloses that material of piezoelectric elements is PZT(Pb(Zr,Ti)O₃), and document 2 discloses that material of piezoelectric elements is PZT and aluminum nitride (AlN).

The electric generators can be classified by types of piezoelectric elements such as thin film types and bulk types. Document 1 discloses thin film type electric generators formed by using a micromachining technique. Document 2 discloses bulk type electric generators.

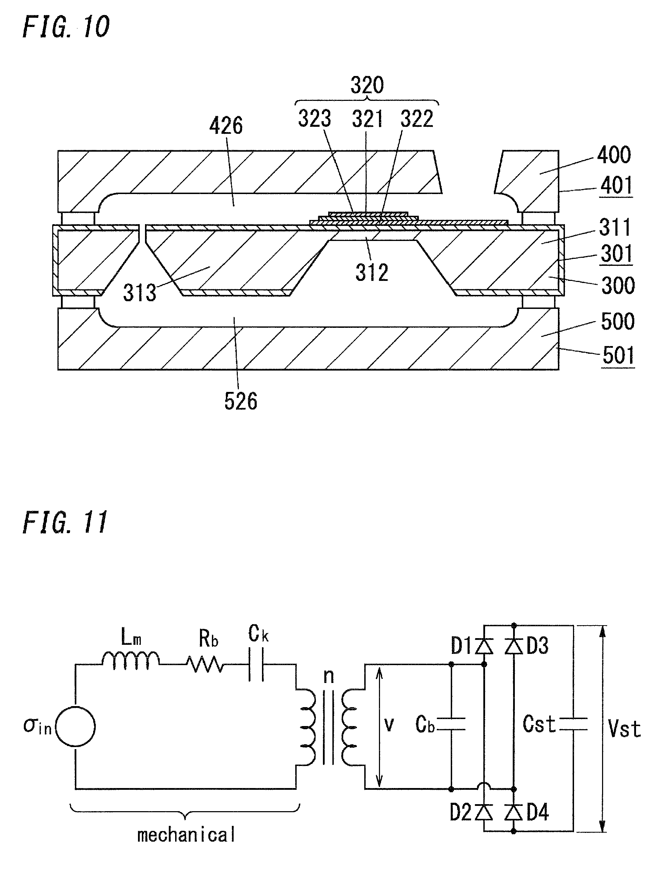

**FIG. 10** shows an electric generator disclosed in document 1. The electric generator includes a device substrate **301** formed of a silicon substrate **300**.

This device substrate **301** includes: a support **311** having a rectangular frame shape; a cantilever (beam) **312** situated inside the support **311** and swingably supported by the support **311;** and a weight **313** provided at a free end of the cantilever **312.**

The electric generator includes an electric generation portion **320.** The electric generation portion **320** is provided on the cantilever **312** of the device substrate **301** and is configured to generate an AC voltage in response to a vibration of the cantilever **312.**

The electric generation portion **320** includes: a lower electrode **322;** a piezoelectric film **321** on the opposite side of the lower electrode **322** from the cantilever **312;** and an upper electrode **323** on the opposite side of the piezoelectric film from the lower electrode **322.**

In this electric generation portion **320,** the lower electrode **322** is a Pt film, and the piezoelectric film **321** is an AlN film or a PZT film, and the upper electrode **323** is an Al film.

The electric generator includes an upper cover substrate **401** and a lower cover substrate **501.** The upper cover substrate **401** is situated over a first surface (upper surface in **FIG. 10**) of the device substrate **301** and is bonded to the support **311.** The lower cover substrate **501** is situated over a second surface (lower surface in **FIG. 10**) of the device substrate **301** and is bonded to the support **311.**

The upper cover substrate **401** and the lower cover substrate **501** are formed of a glass substrate **400** and a glass substrate **500,** respectively.

The device substrate **301** has a movable portion constituted by the cantilever **312** and the weight **313.** Spaces **426** and **526** for allowing displacement of the movable portion are formed between the movable portion and the upper cover substrate **401** and between the movable portion and the lower cover substrate **501,** respectively.

An electric generator disclosed in document 2 includes: a support; a cantilever swingably supported by the support; and a weight provided at an end of the cantilever that is not supported by the support. The cantilever is a bimorph piezoelectric element including stacked two layers of piezoelectric elements.

Further, document 2 discloses an equivalent circuit model of a system including the electric generator. **FIG. 11** shows a circuit diagram of this equivalent circuit model.

The equivalent circuit of the electric generator is constituted by: an equivalent inductor **Lₘ** representing the mass or the inertia of the weight; an equivalent resistor **R_{b}** representing mechanical damping; an equivalent capacitor **Cₖ** representing mechanical stiffness; an equivalent stress σ**ᵢₙ** caused by an external vibration; an equivalent turn ratio **"n"** of a transformer; and a capacitor **C_{b}** representing the electric generation portion.

This equivalent circuit model includes a full-wave rectifier and a storage capacitor **Cₛₜ**. The full-wave rectifier is constituted by a bridge circuit of four diodes **D1, D2, D3,** and **D4**, and performs full-wave rectification on an output voltage **"v"** of the electric generator. The storage capacitor **Cₛₜ** is connected between output terminals of the full-wave rectifier.

The electric generator disclosed in document 1 is a thin film type electric generator. Such a thin film electric generator can be downsized more than a bulk type electric generator disclosed in document 2. Whereas, the thin film type electric generator is lower in output voltage than such a bulk type electric generator. Hence, improvement of the output voltage of the thin film type electric generator has been desired.

An energy harvesting device for storing an output from the electric generator disclosed in document 1 in a capacitor may have a structure in which a full-wave rectifier is connected between output terminals of an electric generation device in a similar manner to that in document 2.

However, in this energy harvesting device, voltage losses (forward voltage drops) may occur in the two diodes **D1** and **D4** in a positive half cycle of the output voltage **"v"** of the electric generator, and other voltage losses may occur in the two diodes **D3** and **D2** in a negative half cycle of the output voltage **"v"** of the electric generator.

Additionally, in the positive half cycle of the output voltage "v" of the electric generator, this energy harvesting device cannot extract electricity except for a period in which the absolute value of the output voltage **"v"** is not less than a total of threshold voltages of the two diodes **D1** and **D4**. Similarly, in the negative half cycle of the output voltage **"v"** of the electric generator, this energy harvesting device cannot extract electricity except for a period in which the absolute value of the output voltage **"v"** is not less than a total of threshold voltages of the two diodes **D3** and **D2**. Hence, it seems to be difficult to charge the storage capacitor **Cₛₜ** efficiently.

### Summary of Invention

In view of the above insufficiency, the present invention has aimed to propose an energy harvesting device capable of charging the electric storage unit efficiently.

The energy harvesting device of the first aspect in accordance with the present invention, includes: an electric generator for charging an electric storage; and an power management circuit configured to operate with power from the electric storage, and to charge the electric storage with power from the electric generator. The electric generator includes two or more electric generation portions each configured to generate AC power when vibrated. The power management circuit includes a first power extraction circuit, a second power extraction circuit, and a switch circuit. The first power extraction circuit includes a first input unit, a first output unit, and a rectification circuit between the first input unit and the first output unit. The rectification circuit is configured to convert AC power received by the first input unit into DC power and provide the converted DC power to the first output unit. The second power extraction circuit includes a second input unit, a second output unit, and a switching circuit which is between the second input unit and the second output unit and is configured to operate with power supplied from the electric storage. The switching circuit is configured to generate DC power by use of AC power received by the second input unit and provide the generated DC power to the second output unit. The switch circuit has a first connection mode of connecting the electric generator and the electric storage to the first input unit and the first output unit, respectively, and a second connection mode of connecting the electric generator and the electric storage to the second input unit and the second output unit, respectively. The switch circuit is configured to, in the first connection mode, connect the two or more electric generation portions to the first input unit such that an effective value of an AC voltage to be provided to the first input unit in the first connection mode is greater than an effective value of an AC voltage to be provided to the second input unit in the second connection mode. The switch circuit is configured to, in the second connection mode, connect the two or more electric generation portions to the second input unit such that the effective value of the AC voltage to be provided to the second input unit in the second connection mode is greater than the effective value of the AC voltage to be provided to the first input unit in the first connection mode.

According to the energy harvesting device of the second aspect in accordance with the present invention, in addition to the first aspect, the switch circuit is configured to, in the first connection mode, make a series circuit of the two or more electric generation portions and connect the series circuit to the first input unit, and is configured to, in the second connection mode, make a parallel circuit of the two or more electric generation portions and connect the parallel circuit to the second input unit.

According to the energy harvesting device of the third aspect in accordance with the present invention, in addition to the first or second aspect, the power management circuit includes a controller configured to operate with power from the electric storage. The controller is configured to, when an output voltage of the electric storage is not less than a predetermined voltage, switch the switch circuit from the first connection mode to the second connection mode.

According to the energy harvesting device of the fourth aspect in accordance with the present invention, in addition to the third aspect, the predetermined voltage is a minimum operating voltage of the power management circuit.

According to the energy harvesting device of the fifth aspect in accordance with the present invention, in addition to the fourth aspect, the minimum operating voltage of the power management circuit is not less than a minimum operating voltage of the second power extraction circuit and also is not less than a minimum operating voltage of the controlled.

According to the energy harvesting device of the sixth aspect in accordance with the present invention, in addition to any one of the first to fifth aspects, the switch circuit is configured to be in the first connection mode while an output voltage of the electric storage is less than a predetermined voltage.

According to the energy harvesting device of the seventh aspect in accordance with the present invention, in addition to the sixth aspect, the switch circuit includes a first switch device between the electric generator and the first input unit, a second switch device between the electric storage and the first output unit, a third switch device between the electric generator and the second input unit, and a fourth switch device between the electric storage and the second output unit. Each of the first switch device and the second switch device is a normally-on switch. Each of the third switch device and the fourth switch device is a normally-off switch.

The energy harvesting device of the eighth aspect in accordance with the present invention, in addition to any one of the first to seventh aspects, further includes the electric storage.

According to the energy harvesting device of the ninth aspect in accordance with the present invention, in addition to the eighth aspect, the electric storage includes a first capacitive element and a second capacitive element. The rectification circuit includes a first rectifying element and a second rectifying element. The first input unit includes a first input terminal and a second input terminal. The first output unit includes a first output terminal, a second output terminal, and a third output terminal. An anode of the first rectifying element and a cathode of the second rectifying element are connected to the first input terminal. A cathode of the first rectifying element is connected to the first output terminal. An anode of the second rectifying element is connected to the second output terminal. The second input terminal is connected to the third output terminal. The switch circuit is configured to, in the first connection mode, connect the two or more electric generation portions in series between the first input terminal and the second input terminal, connect the first capacitive element and the second capacitive element in series between the first output terminal and the second output terminal, and connect the third output terminal to a connection point of the first capacitive element and the second capacitive element.

According to the energy harvesting device of the tenth aspect in accordance with the present invention, in addition to any one of the first to ninth aspects, the switching circuit includes: an energy storage device; a first switch unit between the second input unit and the energy storage device; a second switch unit between the second output unit and the energy storage device; and a control circuit configured to operate with power from the electric storage, and configured to control the first switch unit and the second switch unit to convert an AC voltage received by the second input unit to a DC voltage and provide the converted DC voltage to the second output unit.

According to the energy harvesting device of the eleventh aspect in accordance with the present invention, in addition to the tenth aspect, the control circuit is configured to, while an AC voltage to be provided to the second input unit has a positive or negative polarity, perform a storing operation in which the control circuit keeps turning off the second switch unit and controls the first switch unit so as to store energy in the energy storage device. The control circuit is configured to, when an AC voltage to be provided to the second input unit becomes zero, start a discharging operation in which the control circuit turns off the first switch unit and turns on the second switch unit so as to allow the energy storage device to provide a DC voltage to the second output unit.

According to the energy harvesting device of the twelfth aspect in accordance with the present invention, in addition to the tenth or eleventh aspect, the second input unit includes a third input terminal and a fourth input terminal. The second output unit includes a fourth output terminal, and a fifth output terminal. The first switch unit includes a first switch between a first end of the energy storage device and the third input terminal, a second switch between a second end of the energy storage device and the fourth input terminal, a third switch between the first end of the energy storage device and the fourth input terminal, and a fourth switch between the second end of the energy storage device and the third input terminal. The second switch unit includes a fifth switch between the first end of the energy storage device and the fourth output terminal, and a sixth switch between the second end of the energy storage device and the fifth output terminal. The switch circuit is configured to, in the second connection mode, connect the two or more electric generation portions in parallel between the third input terminal and the fourth input terminal and connect the electric storage between the fourth output terminal and the fifth output terminal. The control circuit is configured to: while an AC voltage to be provided to the second input unit has one of a positive polarity and a negative polarity, turn on the first switch and the second switch and turn off the third switch and the fourth switch while turning off the fifth switch and the sixth switch, so as to perform the storing operation; while an AC voltage to be provided to the second input unit has the other of the positive polarity and the negative polarity, turn off the first switch and the second switch and turn on the third switch and the fourth switch while turning off the fifth switch and the sixth switch, so as to perform the storing operation; and when an AC voltage to be provided to the second input unit becomes zero, turn off the first switch, the second switch, the third switch, and the fourth switch and turn on the fifth switch and the sixth switch, so as to perform the discharging operation.

The energy harvesting device of the thirteenth aspect in accordance with the present invention, in addition to the eleventh or twelfth aspect, further includes a displacement measurement sensor. The electric generator includes a movable portion which is movable from a basic position in response to a vibration given thereto. The two or more electric generation portions are provided to the movable portion, and each configured to generate AC power depending on a displacement of the movable portion from the basic position. The displacement measurement sensor is configured to measure the displacement of the movable portion from the basic position. The control circuit is configured to, when the displacement of the movable portion from the basic position measured by the displacement measurement sensor becomes zero, start the discharging operation.

According to the energy harvesting device of the fourteenth aspect in accordance with the present invention, in addition to the thirteenth aspect, the displacement measurement sensor is a capacitance displacement measurement sensor.

The energy harvesting device of the fifteenth aspect in accordance with the present invention, in addition to the eleventh or twelfth aspect, further includes a current measurement device. The current measurement device is configured to measure an alternating current supplied to the second input unit. The control circuit is configured to, when the current measured by the current measurement device becomes zero, start the discharging operation.

### Brief Description of the Drawings

**FIG. 1** is a diagram illustrating a circuit of an energy harvesting device of the first embodiment;
**FIG. 2** is a schematic plan view illustrating a piezoelectric vibration energy harvester in the energy harvesting device of the first embodiment;
**FIG. 3** is a schematic sectional view along line A-A' of **FIG. 2**;
**FIG. 4** is a diagram illustrating an operation in the first connection mode of the energy harvesting device of the first embodiment;
**FIG. 5** is a diagram illustrating an operation in the second connection mode of the energy harvesting device of the first embodiment;
**FIG. 6** is a diagram illustrating an operation in the second connection mode of the energy harvesting device of the first embodiment;
**FIG. 7** is a diagram illustrating an operation in the second connection mode of the energy harvesting device of the first embodiment;
**FIG. 8** is a diagram illustrating an operation in the second connection mode of the energy harvesting device of the first embodiment;
**FIG. 9** is a diagram illustrating a circuit of an energy harvesting device of the second embodiment;
**FIG. 10** is a sectional view illustrating the prior energy harvesting device; and
**FIG. 11** is a diagram illustrating an equivalent circuit model of a system including the other prior energy harvesting device.

### Description of Embodiments

### (FIRST EMBODIMENT)

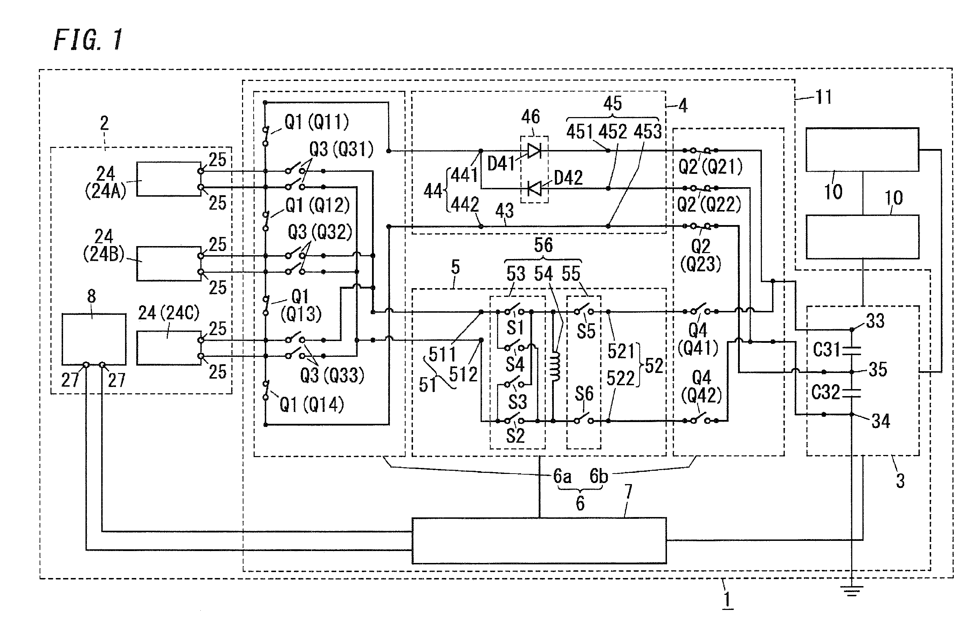

Hereinafter, the energy harvesting device of the present embodiment is described with reference to **FIGS. 1** to **8**.

The energy harvesting device **1** includes a piezoelectric vibration energy harvester (electric generator) **2** and an electric storage unit (electric storage) **3**. The piezoelectric vibration energy harvester **2** includes two or more (in the present embodiment, three) electric generation portions **24** (**24A**, **24B**, and **24C**). Each electric generation portion **24** is configured to generate an AC voltage when receiving an environmental vibration.

The energy harvesting device **1** includes a first power extraction circuit **4**. The first power extraction circuit **4** is constituted by two diodes **D41** and **D42** for rectification. The first power extraction circuit **4** is configured to rectify the AC voltage from the piezoelectric vibration energy harvester **2** to charge (recharge) the electric storage unit **3**.

The energy harvesting device **1** includes a second power extraction circuit **5**. The second power extraction circuit **5** includes electronic analog switches **S1** to **S6** (hereinafter referred to as first to sixth electronic analog switches) and an energy storage device **54.** The second power extraction circuit **5** is configured to receive an AC voltage from the piezoelectric vibration energy harvester **2** and charge the electric storage unit **3** with power derived from the received AC voltage.

The energy harvesting device **1** includes a switch circuit **6** configured to switch between a first connection mode and a second connection mode selectively. In the first connection mode, the energy harvesting device **1** charges the electric storage unit **3** by use of the first power extraction circuit **4.** In the second connection mode, the energy harvesting device **1** charges the electric storage unit **3** by use of the second power extraction circuit **5.**

The energy harvesting device **1** includes a controller **7.** The controller **7** is configured to use power from the electric storage unit **3** to control the second power extraction circuit **5** and the switch circuit **6.** In other words, the controller **7** operates on electricity from the electric storage **3.**

The energy harvesting device **1** includes a power management circuit **11** configured to manage power (electricity) generated by the piezoelectric vibration energy harvester **2.** The power management circuit **11** is constituted by the first power extraction circuit **4,** the second power extraction circuit **5,** the electric storage unit **3,** the switch circuit **6,** and the controller **7.**

The controller **7** is configured to, when an output voltage of the electric storage **3** is not less than a predetermined voltage, switch the switch circuit **6** from the first connection mode to the second connection mode. For example, the predetermined voltage is a minimum operating voltage of the power management circuit **11.** The minimum operating voltage of the power management circuit **11** is not less than a minimum operating voltage of the second power extraction circuit and also is not less than a minimum operating voltage of the controller **7.**

While the switch circuit **6** has the first connection mode, the switch circuit **6** connects a series circuit of the two or more electric generation portions **24** between input terminals **441** and **442** of the first power extraction circuit **4** and connects the electric storage unit **3** between output terminals **451** and **452** of the first power extraction circuit **4.**

While the switch circuit **6** has the second connection mode, the switch circuit **6** connects a parallel circuit of the two or more electric generation portions **24** between input terminals **511** and **512** of the second power extraction circuit **5** and connects the electric storage unit **3** between output terminals **521** and **522** of the second power extraction circuit **5.**

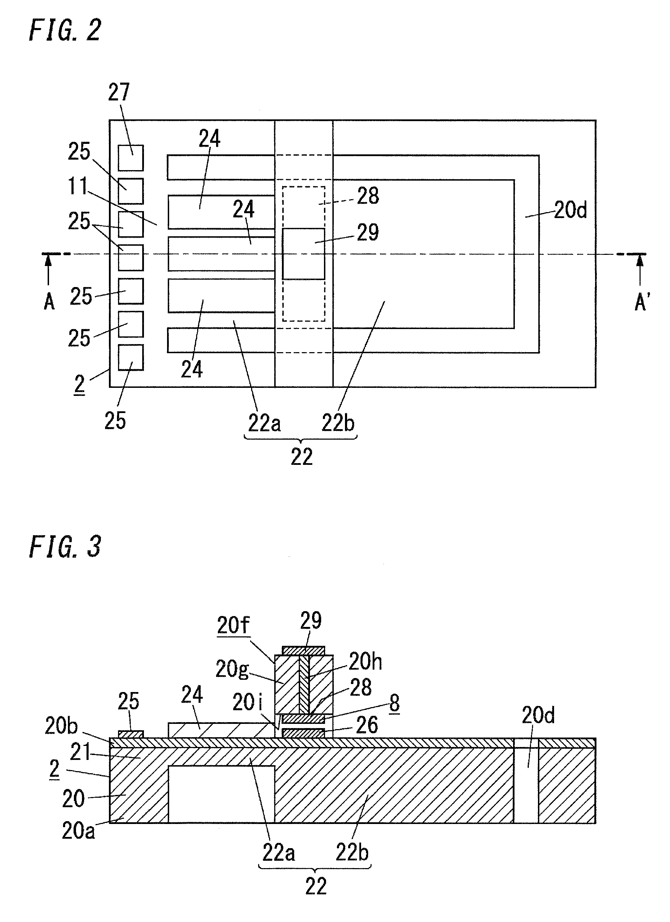

As shown in **FIGS. 2** and **3****,** preferably the piezoelectric vibration energy harvester **2** includes a supporting portion **21** and a movable portion **22**. The movable portion **22** is swingably supported by the supporting portion **21**, and vibrates in response to an environmental vibration. The aforementioned two or more electric generation portions **24** are on the movable portion **22.**

Preferably, the energy harvesting device **1** further includes a displacement measurement sensor **8.** The displacement measurement sensor **8** is configured to determine a displacement of the movable portion **22.** The controller **7** turns on and off the electronic analog switches **S1** to **S6** at near a zero crossing of an AC signal from the displacement measurement sensor **8.**

The components of the energy harvesting device **1** are described in more detail hereinafter.

The piezoelectric vibration energy harvester **2** includes a device substrate **20** including the supporting portion **21,** a cantilever **22a,** and a weight **22b.** The cantilever **22a** is swingably supported by the supporting portion **21** at one end. The weight **22b** is provided to the other end of the cantilever **22a** from the supporting portion **21.**

The cantilever **22a** and the weight **22b** constitute the movable portion **22** of the piezoelectric vibration energy harvester **2**. The two or more electric generation portions **24** are situated on the cantilever **22a**.

Accordingly, the piezoelectric vibration energy harvester **2** generates an AC voltage in response to a vibration of the cantilever **22a**.

In other words, the electric generator **2** includes the movable portion **22** which is movable from a basic position in response to a vibration. The two or more electric generation portions **24** are provided to the movable portion **22**, and each configured to generate AC power depending on displacement of the movable portion **22** from the basic position.

The device substrate **20** is formed by use of a first substrate **20a.** The first substrate **20a** may be a single crystal silicon substrate with a first surface which is a (100) surface. The first substrate **20a** is not limited thereto, and may be a polycrystalline silicon substrate.

An insulating film **20b** is on the first surface of the first substrate **20a** of the device substrate **20** and electrically insulates the electric generation portions **24** from the first substrate **20a**.

The first substrate **20a** is not limited to a silicon substrate, but may be one selected from an SOI (Silicon on Insulator) substrate, a magnesium oxide (MgO) substrate, a metal substrate, a glass substrate, and a polymer substrate, for example. When the first substrate **20a** is an insulator substrate such as an MgO substrate, a glass substrate, and a polymer substrate, the insulating film **20b** is not necessary but may be provided.

The supporting portion **21** of the device substrate **20** has a frame shape (in the present embodiment, a rectangular frame shape). The cantilever **22a** and the weight **22b** are situated inside the supporting portion **21.**

The device substrate **20** includes a slit **20d** having a U-shape in a plan view. The slit **20d** surrounds the movable portion **22** constituted by the cantilever **22a** and the weight **22b.** Thus, the movable portion **22** is spatially separated from the supporting portion **21** except for a connection part of the movable portion **22** connected to the supporting portion **21.**

It is sufficient that the supporting portion **21** has such a shape as to support the movable portion **22** swingably. Hence, the supporting portion **21** need not have a frame shape.

The electric generation portions **24** are formed over the first surface of the device substrate **20.** Each electric generation portion **24** is constituted by a piezoelectric converter including a pair of two electrodes opposite each other and a piezoelectric element between the pair of two electrodes. The pair of two electrodes of the electric generation portion **24** are arranged over a first surface of the cantilever **22a** of a thickness direction of the cantilever **22a** so as to be separate from each other in this thickness direction.

In the piezoelectric vibration energy harvester **2,** a vibration of the movable portion **22** applies a mechanical stress to the piezoelectric element of the electric generation portion **24** and this applied stress causes a difference between charge densities between one and the other of the two electrodes. Thus, the electric generation portion **24** generates an AC voltage. In brief, the electric generation portion **24** of the piezoelectric vibration energy harvester **2** generates electricity by use of a piezoelectric effect of a piezoelectric material.

The piezoelectric vibration energy harvester **2** has an open voltage which is a sinusoidal AC voltage depending on a vibration of the piezoelectric element caused by an environmental vibration.

The piezoelectric vibration energy harvester **2** is designed to generate electricity by use of an environmental vibration with a frequency equal to a resonance frequency of the piezoelectric vibration energy harvester **2**. Such an environmental vibration may include various environmental vibrations (external vibrations) such as a vibration caused by an FA device in operation, a vibration caused by a vehicle in motion, and a vibration caused by human walking.

When the frequency of the environmental vibration is equal to the resonance frequency of the energy harvesting device **1,** a frequency of the AC voltage generated by the energy harvesting device **1** is the same as the resonance frequency of the energy harvesting device **1**.

Note that, the external vibrations may include various environmental vibrations such as a vibration caused by an FA device in operation, a vibration caused by a vehicle in motion, and a vibration caused by human walking, for example. In the present embodiment, an FA device which causes a vibration with a frequency of 475 Hz is considered as an external vibration source which causes such an external vibration. Each of the two or more electric generation portions **24** of the piezoelectric vibration energy harvester **2** serves as a polar capacitor.

The piezoelectric material of the piezoelectric element is PZT. However, the piezoelectric material is not limited thereto but may be PZT-PMN(Pb(Mn,Nb)O₃) or PZT doped with other impurities. Alternatively, the piezoelectric material may be selected from AlN, ZnO, KNN (K_{0.5}Na_{0.5}NTbO₃), KN (KNbO₃), NN (NaNbO₃), and KNN doped with impurities (e.g., Li, Nb, Ta, Sb, and Cu).

The pair of two electrodes includes one electrode (hereinafter referred to as "first electrode", if necessary) situated on one side of the piezoelectric element close to the movable portion **22**, and the other electrode (hereinafter referred to as "second electrode", if necessary) situated on the opposite side of the piezoelectric element from the movable portion **22**. The first electrode may be of Pt, Au, Al, or Ir, for example. The second electrode may be of Au, Mo, Al, Pt, or Ir, for example.

The piezoelectric vibration energy harvester **2** is a thin electric generator. For example, the first electrode has a thickness of 500 nm, the piezoelectric element has a thickness of 600 nm, and the second electrode has a thickness of 100 nm. These values are merely examples and these thicknesses are not limited to particular values.

The first electrode may be formed with a combination of a thin film formation technique (e.g., sputtering, CVD, and vapor deposition) and a patterning technique using a photolithography technique and an etching technique.

The piezoelectric element may be formed with a combination of a thin film formation technique (e.g., sputtering, CVD, and a sol-gel process) and a patterning technique using a photolithography technique and an etching technique.

The second electrode may be formed with a combination of a thin film formation technique (e.g., sputtering, CVD, and vapor deposition) and a patterning technique using a photolithography technique and an etching technique.

Alternatively, the second electrode may be a sheet electrode (also referred to as "electrode sheet"), for example. The second electrode of the sheet electrode may be provided to the piezoelectric element by overlaying the piezoelectric element with the second electrode of the sheet electrode with a vacuum lamination method. The sheet electrode may be metal foil such as aluminum foil, for example. Alternatively the sheet electrode may be obtained by coating a lamination sheet with electrode material with sputtering.

The piezoelectric vibration energy harvester **2** may include a buffer layer between the device substrate **20** and the first electrode. The buffer layer may be of material appropriately selected depending on the piezoelectric material of the piezoelectric element. When the piezoelectric material of the piezoelectric element is PZT, it is preferable that the buffer layer be of SrRuO₃, (Pb,La)TiO₃, PbTiO₃, MgO, or LaNiO₃, for example. Alternatively, the buffer layer may be a laminate of a Pt film and a SrRuO₃ film, for example. Provision of the buffer layer can cause an improvement of crystallinity of the piezoelectric element.

The piezoelectric vibration energy harvester **2** includes two or more (in the present embodiment, six) pads **25.** The pads **25** are situated on the first surface of the device substrate **20.** The pads **25** are electrically connected to electrodes including the first electrodes and the second electrodes of the electric generation portions **24.**

In summary, in the piezoelectric vibration energy harvester **2,** the pads **25** are associated with the electrodes individually, and each pad **25** is electrically connected to an associated electrode through a wire (metal wire) not shown. Within the piezoelectric vibration energy harvester **2** itself, the electric generation portions **24** are electrically insulated from each other.

Each pad **25** is formed on a portion of the device substrate **20** corresponding to the supporting portion **21.**

The switch circuit **6** can connect all the electric generation portions **24** of the piezoelectric vibration energy harvester **2** in series or in parallel with each other. When all the electric generation portions **24** are connected in series with each other, the piezoelectric vibration energy harvester **2** can produce the output voltage greater than the output voltage from a single electric generation portion with a size equal to the total of the sizes of all the electric generation portions **24.** The switch circuit **6** is described later.

The piezoelectric vibration energy harvester **2** further includes two pads **27** and **29** of the displacement measurement sensor **8** in addition to the aforementioned pads **25**. The displacement measurement sensor **8** is described later.

The structure of the electric generation portion **24** is not limited to the aforementioned example. For example, the electric generation portion **24** may have a modified structure in which the pair of two electrodes are electrodes formed on opposite side surfaces of the piezoelectric element close to the weight **22b** and the supporting portion **21** over the first surface of the cantilever **22a** in the thickness direction of the cantilever **22a** respectively. In this case, each electrode may be of Au, Pt, Ir, Al, or Mo, for example.

Each electrode may be constituted by a first conductive film on the corresponding side surface of the piezoelectric element and a second conductive film on this first conductive electrode. In this case, the second conductive film may be of Au, Pt, Ir, Al, or Mo, and the first conductive film may be of Ti. This can cause an improvement of adhesiveness between the piezoelectric element and each electrode. The material of the first conductive film may be appropriately selected depending on materials of the piezoelectric element and the second conductive film. For example, the material of the first conductive film may be selected from Cr, TiN, and TaN in addition to Ti.

In the aforementioned modified structure, with regard to thicknesses in the thickness direction of the cantilever **22a**, the piezoelectric element has a thickness of 600 nm, and each electrode has a thickness of 600 nm. These thicknesses are not limited.

The aforementioned modified structure may include a buffer layer between the device substrate 20 and the first electrode. Provision of the buffer layer can cause an improvement of crystallinity of the piezoelectric element and therefore can cause an improvement of piezoelectricity of the piezoelectric element. The buffer layer may be of material appropriately selected depending on the piezoelectric material of the piezoelectric element. When the piezoelectric material of the piezoelectric element is PZT, it is preferable that the buffer layer be of SrRuO₃, (Pb,La)TiO₃, PbTiO₃, MgO, or LaNiO₃, for example. Alternatively, the buffer layer may be a laminate of a Pt film and a SrRuO₃ film, for example.

The displacement measurement sensor **8** is a capacitance displacement measurement sensor. The displacement measurement sensor **8** includes a movable electrode **26** and a fixed electrode **28.** The movable electrode **26** is provided to the movable portion **22,** and the fixed electrode **28** is opposite the movable electrode **26.**

The fixed electrode **28** is provided to a second substrate **20f bonded** to the device substrate **20.**

The second substrate **20f** is formed of a glass substrate **20g.** The second substrate 20f is provided with a first recess **20i** in a side opposite the device substrate **20.** The first recess **20i** forms a space for swing of the movable portion **22.** The fixed electrode **28** is on an inner bottom surface of the first recess **20i.**

The piezoelectric vibration energy harvester **2** may include a cover substrate bonded to a second surface of the device substrate **20.** The cover substrate includes a second recess for forming a space for allowing swing of the movable portion **22.**

With regard to the energy harvesting device **1,** instead of bonding the cover substrate to the piezoelectric vibration energy harvester **2,** a second recess or an opening (through hole) for allowing swing of the movable portion **22** may be provide to a mounting substrate (e.g., a printed wiring board and a package) on which the piezoelectric vibration energy harvester **2** is to be mounted.

The displacement measurement sensor **8** includes the pad **27** and the pad **29**. The pad **27** is electrically connected to the movable electrode **26** through a metal wire not shown. The pad **29** is electrically connected to the fixed electrode **28** through a through hole wire **20h** penetrating through the glass substrate **20g** in a thickness direction of the glass substrate **20g**. The second substrate **20f is** positioned such that the fixed electrode **28** is situated on the side facing the movable portion **22** and the pad **29** is situated on the opposite side of the second substrate **20f** from the movable portion **22**.

As clearly understood from the above description, the displacement measurement sensor **8** that is a capacitance displacement measurement sensor includes a variable capacity capacitor having a pair of electrodes defined by the movable electrode **26** and the fixed electrode **28**.

According to the displacement measurement sensor **8**, a capacitance of the variable capacity capacitor varies with a change in a distance between the movable electrode **26** and the fixed electrode **28** caused by a vibration (swing) of the movable portion **22.** Consequently, the capacitance of the displacement measurement sensor varies depending on a displacement of the movable electrode **26.**

While a DC bias voltage is applied between the movable electrode **26** and the fixed electrode **28** by the controller 7, a slight change in the voltage between the movable electrode **26** and the fixed electrode **28** occurs depending on a change in the electrostatic capacitance. Accordingly, the controller **7** can determine the displacement of the movable portion **22** with reference to the change in this voltage.

As described above, the displacement measurement sensor **8** is configured to measure the displacement of the movable portion **22** from the basic position.

The structure of the piezoelectric vibration energy harvester **2** is not limited to the aforementioned example. For example, in another structure of the piezoelectric vibration energy harvester **2,** a first cover substrate and a second cover substrate may be bonded to the opposite sides of the device substrate **20** in the thickness direction of the device substrate **20.**

In this structure, for example, preferably, the first cover substrate and the second cover substrate include a first recess and a second recess respectively, each of the first recess and the second recess forms a space for allowing swing of the movable portion **22,** and the fixed electrode **28** is situated on an inner bottom surface of the first recess.

According to this structure, it is possible to increase the mass of the weight **22b** of the movable portion **22** of the piezoelectric vibration energy harvester **2,** in contrast to a structure in which the first substrate and the second substrate are devoid of the first recess and the second recess respectively and the opposite surfaces of the movable portion **22** are closer to the center of the first substrate **20a** than the opposite surfaces of the first substrate **20a** in the thickness direction of the first substrate **20a** are.

The structure of the displacement measurement sensor **8** is not limited to the aforementioned example, however, it is preferable that the displacement measurement sensor **8** be a capacitance displacement measurement sensor. In contrast to the energy harvesting device **1** including the displacement measurement sensor **8** that is a piezoelectric displacement measurement sensor, it is possible to reduce power necessary to measure a displacement of the movable portion **22** by the displacement measurement sensor **8**.

As described above, it is preferable that the controller **7** turn on and off the electronic analog switches **S1** to **S6** of the second power extraction circuit **5** at near the zero crossing of the AC signal outputted from the displacement measurement sensor **8.**

The controller **7** outputs control signals for turning on and off the electronic analog switches **S1** to **S6.** Accordingly, the energy harvesting device **1** in the second connection mode can efficiently extract generated electricity from the piezoelectric vibration energy harvester **2.** As a result of that, the electric storage unit **3** can be charged efficiently.

While a functional device **10** is connected between opposite ends of the electric storage unit **3,** the energy harvesting device **1** can allow the functional device **10** to operate on electricity from the electric storage unit **3**.

The functional device **10** may be selected from a sensor (e.g., a temperature sensor, an acceleration sensor, a pressure sensor), a solid light emitting device (e.g., a light emitting diode and a semiconductor laser diode), and an arithmetic device (e.g., a wireless communication device and an MPU [Micro Processor Unit]). The number of functional devices **10** and the connection configuration thereof may be appropriately determined based on the application of the energy harvesting device **1**.

The electric storage (electric storage unit) **3** includes a capacitor **C31** serving as a first capacitive element and a capacitor **C32** serving as a second capacitive element. Each of the first capacitive element and the second capacitive element may be constituted by two or more capacitors.

The electric storage **3** includes a first power terminal **33,** a second power terminal **34,** and a ground terminal **35.** In the present embodiment, the capacitor **C31** has a first end connected to a first end of the capacitor **C32.** The first power terminal **33** is a second end of the capacitor **C31.** The second power terminal **34** is a second end of the capacitor **C32.** The ground terminal **35** is a connection point of the first ends of the capacitors **C31** and **C32.**

The electric storage unit **3** is a series circuit of the two capacitors **C31** and **C32**. Further, the capacitors **C31** and **C32** have the same specification and have the same characteristics.

Each of the capacitors **C31** and **C32** has a capacitance of 10 µF. This numerical value is merely an example, and does not give any limitations.

Each of the capacitors **C31** and **C32** is a surface-mount capacitor. However, each of the capacitors **C31** and **C32** is not limited to such a surface-mount capacitor.

Hereinafter, the capacitor **C31** is referred as a first capacitor **C31,** and the other capacitor **C32** is referred to as a second capacitor **C32,** depending on a situation.

The electric storage unit **3** is not limited to a circuit of the two capacitors **C31** and **C32** but may be a single capacitor.

The first power extraction circuit **4** includes a first input unit **44,** a first output unit **45,** and a rectification circuit **46** between the first input unit **44** and the first output unit **45**.

The rectification circuit **46** is configured to convert AC power received by the first input unit **44** into DC power and provide the converted DC power to the first output unit **45**.

The rectification circuit **46** includes the diode **D41** serving as a first rectifying element and the diode **D42** serving as a second rectifying element. Each of the first rectifying element and the second rectifying element may be constituted by one or more diodes.

The first input unit **44** includes the first input terminal **441** and the second input terminal **442**.

The first output unit **45** includes the first output terminal **451,** the second output terminal **452,** and a third output terminal **453.**

An anode of the diode (first rectifying element) **D41** and a cathode of the diode (second rectifying element) **D42** are connected to the first input terminal **441.** A cathode of the diode **D41** is connected to the first output terminal **451.** An anode of the diode **D42** is connected to the second output terminal **452.** The second input terminal **442** is connected to the third output terminal **453.**

In more detail, the first power extraction circuit **4** includes a series circuit of the two diodes **D41** and **D42,** and a single wire **43** electrically insulated from this series circuit.

Further, the diodes **D41** and **D42** have the same specification and have the same characteristics. Each of the diodes **D41** and **D42** is a silicon diode and has a forward voltage drop of about 0.6 to 0.7 V. Each of the diodes **D41** and **D42** is a surface-mount diode. However, each of the diodes **D41** and **D42** is not limited to such a surface-mount diode.

The wire **43** may be part of a patterned conductor of the aforementioned printed wiring board on which the piezoelectric vibration energy harvester **2** and the diodes **D41** and **D42** are to be mounted.

The connection point of the two diodes **D41** and **D42** and a first end of the wire **43** of the first power extraction circuit **4** are electrically connected to the piezoelectric vibration energy harvester **2** in the first connection mode, and is electrically separated from the piezoelectric vibration energy harvester **2** in the second connection mode.

The cathode of the diode **D1,** the anode of the further diode **D2**, and a second end of the wire **43** of the first power extraction circuit **4** are electrically connected to the electric storage unit **3** in the first connection mode, and is electrically separated from the electric storage unit **3** in the second connection mode.

Hereinafter, the diode **D41** is referred as a first diode **D41,** and the other diode **D42** is referred to as a second diode **D42,** depending on a situation.

The second power extraction circuit **5** includes a second input unit **51,** a second output unit **52,** and a switching circuit **56.** The switching circuit **56** is between the second input unit **51** and the second output unit **52,** and is configured to operate with power supplied from the electric storage **3.**

The switching circuit **56** is configured to generate DC power by use of AC power received by the second input unit **51** and provide the generated DC power to the second output unit **52.**

The switching circuit **56** includes the energy storage device **54,** a first switch unit **53** between the second input unit **51** and the energy storage device **54,** a second switch unit **55** between the second output unit **52** and the energy storage device **54.**

The second input unit **51** includes the third input terminal **511** and the fourth input terminal **512.**

The second output unit **52** includes the fourth output terminal **521** and the fifth output terminal **522.**

The first switch unit **53** includes the first switch (first electronic analog switch) **S1** between a first end of the energy storage device **54** and the third input terminal **511,** a second switch (second electronic analog switch) **S2** between a second end of the energy storage device **54** and the fourth input terminal **512,** the third switch (third electronic analog switch) **S3** between the first end of the energy storage device **54** and the fourth input terminal **512,** and the fourth switch (fourth electronic analog switch) **S4** between the second end of the energy storage device **54** and the third input terminal **511.** Each of the switches **S1** to **S4** may be constituted by one or more switches.

The second switch unit **55** includes the fifth switch (fifth electronic analog switch) **S5** between the first end of the energy storage device **54** and the fourth output terminal **521**, and the sixth switch (sixth electronic analog switch) **S6** between the second end of the energy storage device **54** and the fifth output terminal **522**. Each of the switches **S5** and **S6** may be constituted by one or more switches.

In the present embodiment, the controller **7** functions as a control circuit of the switching circuit **56.**

In other words, the controller **7** is the control circuit configured to operate with power from the electric storage **3,** and configured to control the first switch unit **53** and the second switch unit **55** to convert an AC voltage received by the second input unit **51** to a DC voltage and provide the converted DC voltage to the second output unit **52.**

The controller **7** is configured to, while an AC voltage to be provided to the second input unit **51** has a positive or negative polarity, perform a storing operation in which the controller **7** keeps turning off the second switch unit **55** and controls the first switch unit **53** so as to store energy in the energy storage device **54**.

Concretely, the controller **7** is configured to, while an AC voltage to be provided to the second input unit **51** has a positive polarity, turn on the first switch **S1** and the second switch **S2** and turn off the third switch **S3** and the fourth switch **S4** while turning off the fifth switch **S5** and the sixth switch **S6,** so as to perform the storing operation (first storing operation).

The controller **7** is configured to, while an AC voltage to be provided to the second input unit **51** has a negative polarity, turn on the third switch **S3** and the fourth switch **S4** and turn off the first switch **S1** and the second switch **S2** while turning off the fifth switch **S5** and the sixth switch **S6,** so as to perform the storing operation (second storing operation).

Note that, the controller **7** may be configured to: perform the first storing operation while an AC voltage to be provided to the second input unit **51** has a negative polarity: and perform the second storing operation while an AC voltage to be provided to the second input unit **51** has a positive polarity.

The controller **7** is configured to, when an AC voltage to be provided to the second input unit **51** becomes zero, start a discharging operation in which the controller **7** turns off the first switch unit **53** and turns on the second switch unit **55** so as to allow the energy storage device **54** to provide a DC voltage to the second output unit **52**. In the present embodiment, the controller **7** is configured to start the discharging operation when the displacement of the movable portion **22** from the basic position measured by the displacement measurement sensor **8** becomes zero.

Concretely, the controller **7** is configured to, when an AC voltage to be provided to the second input unit **51** becomes zero, turn off the first switch **S1,** the second switch **S2,** the third switch **S3,** and the fourth switch **S4** and turn on the fifth switch **S5** and the sixth switch **S6,** so as to perform the discharging operation.

In more detail, the second power extraction circuit **5** includes a pair of the input terminals **511** and **512** and a pair of the output terminals **521** and **522**.

The second power extraction circuit **5** includes a series circuit of the first electronic analog switch **S1,** the energy storage device **54,** and the second electronic analog switch **S2,** and this series circuit is between the input terminal **511** and the further input terminal **512.**

The energy storage device **54** is an inductor. The energy storage device **54** may be constituted by one or more inductors.

The second power extraction circuit **5** includes the third electronic analog switch **S3** between the connection point of the first electronic analog switch **S1** and the energy storage device **54** and the further input terminal **512.**

The second power extraction circuit **5** includes the fourth electronic analog switch **S4** between the connection point of the energy storage device **54** and the second electronic analog switch **S2** and the input terminal **511.**

The second power extraction circuit **5** includes the fifth electronic analog switch **S5** between the connection point of the first electronic analog switch **S1** and the energy storage device **54** and the output terminal **521.**

The second power extraction circuit **5** includes the sixth electronic analog switch **S6** between the connection point of the energy storage device **54** and the second electronic analog switch **S2** and the further output terminal **522**.

The first to sixth electronic analog switches **S1** to **S6** are turned on and off by the controller **7** in the second connection mode.

In is preferable that each of the first to sixth electronic analog switches **S1** to **S6** be an n-channel MOS transistor. In this case, compared with each of the first to sixth electronic analog switches **S1** to **S6** constituted by a p-channel MOS transistor, each of the first to sixth electronic analog switches **S1** to **S6** can have a lowered on-resistance and operate rapidly. Each of the first to sixth electronic analog switches **S1** to **S6** is preferably a normally-off switch.

The switch circuit **6** has: the first connection mode of connecting the electric generator **2** and the electric storage **3** to the first input unit **44** and the first output unit **45,** respectively; and the second connection mode of connecting the electric generator **2** and the electric storage **3** to the second input unit **51** and the second output unit **52,** respectively. In other words, according to the first connection mode, the first power extraction circuit **4** is interposed between the electric generator **2** and the electric storage **3.** According to the second connection mode, the second power extraction circuit **5** is interposed between the electric generator **2** and the electric storage **3.**

The switch circuit **6** is configured to, in the first connection mode, connect the two or more electric generation portions **24** to the first input unit **44** such that an effective value of an AC voltage to be provided to the first input unit **44** in the first connection mode is greater than an effective value of an AC voltage to be provided to the second input unit **51** in the second connection mode.

The switch circuit **6** is configured to, in the second connection mode, connect the two or more electric generation portions **24** to the second input unit **51** such that the effective value of the AC voltage to be provided to the second input unit **51** in the second connection mode is greater than the effective value of the AC voltage to be provided to the first input unit **44** in the first connection mode.

The switch circuit **6** is configured to, in the first connection mode, make a series circuit of the two or more electric generation portions **24** and connect the series circuit to the first input unit **44,** and is configured to, in the second connection mode, make a parallel circuit of the two or more electric generation portions **24** and connect the parallel circuit to the second input unit **51**.

The switch circuit **6** is configured to, in the first connection mode, connect the two or more electric generation portions **24** in series between the first input terminal **441** and the second input terminal **442,** connect the first capacitive element (capacitor) **C31** and the second capacitive element (capacitor) **C32** in series between the first output terminal **451** and the second output terminal **452,** and connect the third output terminal **453** to the connection point of the first capacitive element **C31** and the second capacitive element **C32**.

The switch circuit **6** is configured to, in the second connection mode, connect the two or more electric generation portions **24** in parallel between the third input terminal **511** and the fourth input terminal **512** and connect the electric storage **3** between the fourth output terminal **521** and the fifth output terminal **522**.

In the present embodiment, the switch circuit **6** includes: at least one first switch device **Q1** (**Q11**, **Q112, Q13,** and **Q14**) between the electric generator 2 and the first input unit **44;** at least one second switch device **Q2** (**Q21, Q22**, and **Q23**) between the electric storage **3** and the first output unit **45;** at least one third switch device **Q3** (**Q31**, **Q32,** and **Q33**) between the electric generator **2** and the second input unit **51**, and at least one fourth switch device **Q4** (**Q41** and **Q42**) between the electric storage **3** and the second output unit **52**. Each of the first switch device **Q1** and the second switch device **Q2** is a normally-on switch. Each of the third switch device **Q3** and the fourth switch device **Q4** is a normally-off switch. Each of the switch devices **Q1** to **Q4** may be constituted by one or more switches.

In more detail, the switch circuit **6** includes the first switch device **Q1** interposed between the piezoelectric vibration energy harvester **2** and the first power extraction circuit **4,** the second switch device **Q2** interposed between the first power extraction circuit **4** and the electric storage unit **3,** the third switch device **Q3** interposed between the piezoelectric vibration energy harvester **2** and the second power extraction circuit **5,** and the fourth switch device **Q4** interposed between the piezoelectric vibration energy harvester **2** and the electric storage unit **3**.

To enable connection of a series circuit of all the electric generation portions **24** of the piezoelectric vibration energy harvester **2** to the first power extraction circuit **4,** the switch circuit **6** includes the four first switch devices **Q1** (**Q11, Q12, Q13,** and **Q14**).

The first switch device **Q11** is interposed between the first pad **25** of the electric generation portion **24A** and the first input terminal **441** of the first input unit **44**.

The first switch device **Q12** is interposed between the second pad **25** of the electric generation portion **24A** and the first pad **25** of the electric generation portion **24B**.

The first switch device **Q13** is interposed between the second pad **25** of the electric generation portion **24B** and the first pad **25** of the electric generation portion **24C**.

The first switch device **Q14** is interposed between the second pad **25** of the electric generation portion **24C** and the second input terminal **442** of the first input unit **44**.

In summary, the switch circuit **6** includes the two first switch devices **Q1** (**Q12** and **Q13**) connected between the pads **25** and **25** with different polarities of the different electric generation portions **24** to be connected in series with each other. The switch circuit **6** includes the two first switch devices **Q1** Q**11** and **Q14**). One of the two first switch devices **Q1** (**Q11** and **Q14**) is provided between one of the pads **25** and **25** at the opposite ends of the series circuit of all the electric generation portions and one of the input terminals **441** and **442** of the first power extraction circuit **4**, and the other the two first switch devices **Q1** (**Q11** and **Q14**) is provided between the other of the pads **25** and **25** at the opposite ends of the series circuit of all the electric generation portions and the other of the input terminals **441** and **442** of the first power extraction circuit **4**.

Further, to enable connection of a parallel circuit of all the electric generation portions **24** of the piezoelectric vibration energy harvester **2** to the second power extraction circuit **5,** the switch circuit **6** includes the total six third switch devices **Q3** (**Q31, Q32,** and **Q33**).

One of the third switch devices **Q31** is interposed between the third input terminal **511** of the second input unit **51** and one of the pads **25** of the electric generation portion **24A,** and the other of the third switch devices **Q31** is interposed between the fourth input terminal **512** of the second input unit **51** and the other of the pads **25** of the electric generation portion **24A**.

One of the third switch devices **Q32** is interposed between the third input terminal **511** of the second input unit **51** and one of the pads **25** of the electric generation portion **24B,** and the other of the third switch devices **Q32** is interposed between the fourth input terminal **512** of the second input unit **51** and the other of the pads **25** of the electric generation portion **24B**.

One of the third switch devices **Q33** is interposed between the third input terminal 511 of the second input unit **51** and one of the pads **25** of the electric generation portion **24C,** and the other of the third switch devices **Q33** is interposed between the fourth input terminal **512** of the second input unit **51** and the other of the pads **25** of the electric generation portion **24C.**

In summary, the switch circuit **6** includes the total six third switch devices **Q3** including the pair of the third switch devices **Q3** individually interposed between the input terminals **511** and **512** of the second power extraction circuit **5** and the pads **25** and **25** with different polarities for each of all the electric generation portions **24** to be connected in parallel with each other.

Further, to enable connection between the first power extraction circuit **4** and the electric storage unit **3,** the switch circuit **6** includes the three second switch devices **Q2** (**Q21, Q22,** and **Q23**).

The second switch device **Q21** is interposed between the first output terminal **451** of the first output unit **45** and the first power terminal **33** of the electric storage **3**.

The second switch device **Q22** is interposed between the second output terminal **452** of the first output unit **45** and the second power terminal **34** of the electric storage **3.**

The second switch device **Q23** is interposed between the third output terminal **453** of the first output unit **45** and the ground terminal **35** of the electric storage **3.**

In summary, the switch circuit **6** includes the three second switch devices **Q2.** One of the three second switch devices **Q2** is interposed between the cathode of the first diode **D41** of the first power extraction circuit **4** and the first end of the first capacitor **C31,** another of the three second switch devices **Q2** is interposed between the second end of the wire **43** and the connection point of the second end of the first capacitor **C31** and the first end of the second capacitor **C32,** and the other of the three second switch devices **Q2** is interposed between the anode of the second diode **D42** and the second end of the second capacitor **C32.**

Further, to enable connection between the second power extraction circuit **5** and the electric storage unit **3,** the switch circuit **6** includes the two fourth switch devices **Q4** (**Q41** and **Q42**).

The fourth switch device **Q41** is interposed between the fourth output terminal **521** of the second output unit **52** and the first power terminal **33** of the electric storage **3.**

The fourth switch device **Q42** is interposed between the fifth output terminal **522** of the second output unit **52** and the second power terminal **34** of the electric storage **3.**

In summary, the switch circuit **6** includes the two fourth switch devices **Q4** interposed between the output terminals of the second power extraction circuit **5** and the ends of the electric storage unit **3** individually.

In the switch circuit **6,** it is preferable that each of the first switch device **Q1** and the second switch device **Q2** be a normally-on switch and each of the third switch device **Q3** and the fourth switch device **Q4** be a normally-off switch.

According to this configuration, even if the electric storage unit **3** fails to supply a voltage not less than the minimum operating voltage of the controller **7** to the controller **7** and the controller **7** is not in operation, the energy harvesting device **1** can have the first connection mode. Thus, the energy harvesting device **1** can charge the electric storage unit **3** with electricity from the piezoelectric vibration energy harvester **2.**

In other words, the switch circuit **6** is configured to be in the first connection mode while the output voltage of the electric storage **3** is less than the predetermined voltage.

Even in an initial state in which the electric storage unit 3 is not charged, the energy harvesting device **1** can charge the electric storage unit **3** with electricity from the piezoelectric vibration energy harvester **2** without using an external power source.

It is preferable that each of the first switch device **Q1** and the second switch device **Q2** be constituted by a normally-on MOS transistor. Each of the first switch device **Q1** and the second switch device **Q2** is not limited thereto. For example, each of the first switch device **Q1** and the second switch device **Q2** may be constituted by a contact (break contact) of a normally-on relay.

It is preferable that each of the third switch device **Q3** and the fourth switch device **Q4** be constituted by a normally-off MOS transistor. Each of the third switch device **Q3** and the fourth switch device **Q4** is not limited thereto. For example, each of the third switch device **Q3** and the fourth switch device **Q4** may be constituted by a contact (make contact) of a normally-off relay.

The numbers of first switch devices **Q1,** second switch devices **Q2,** third switch devices **Q3**, and fourth switch devices **Q4** are not limited particularly. It is necessary to appropriately determine the numbers of first switch devices **Q1** and third switch devices **Q3** based on the number of electric generation portions **24** of the piezoelectric vibration energy harvester **2.**

The first switch device **Q1** and the third switch device **Q3** of the aforementioned switch circuit **6** constitute a first switching unit **6a** provided between the piezoelectric vibration energy harvester **2** and the first power extraction circuit **4** as well as the second power extraction circuit **5.**

Further, the second switch device **Q2** and the fourth switch device **Q4** of the switch circuit **6** constitute a second switching unit **6b** provided between the electric storage unit **3** and the first power extraction circuit **4** as well as the second power extraction circuit **5.**

In the first connection mode of the energy harvesting device **1,** the connection point of the two diodes **D41** and **D42** is connected to one of output ends of the piezoelectric vibration energy harvester **2** and the connection point of the two capacitors **C31** and **C32** is connected to the other of the output ends of the piezoelectric vibration energy harvester **2.**

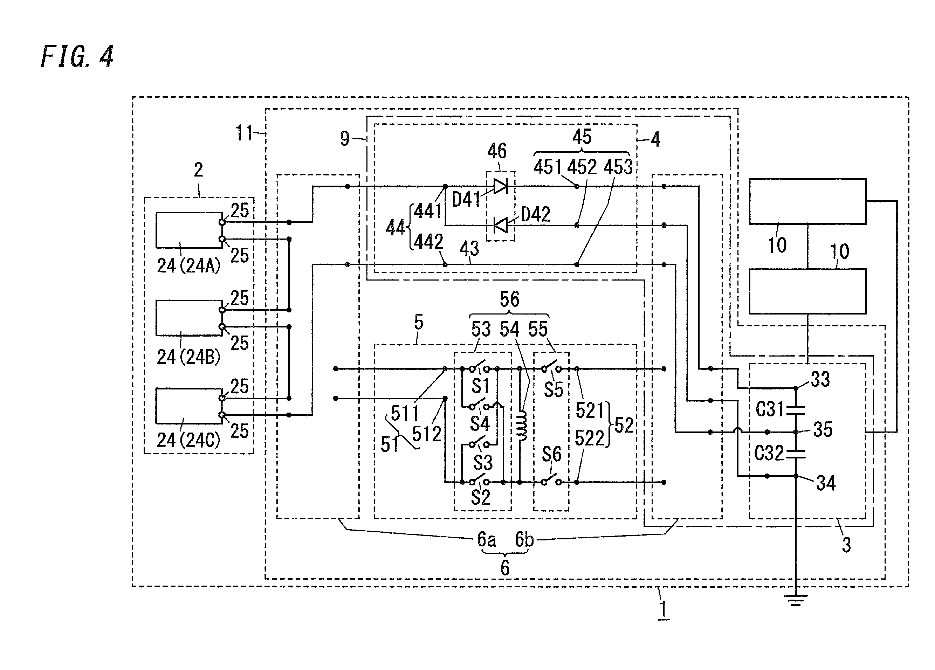

In other words, in the first connection mode, the energy harvesting device **1** has a full-wave voltage doubler **9** configured to perform voltage doubler rectification on an AC voltage generated by the piezoelectric vibration energy harvester **2** (see **FIG. 4**).

In this full-wave voltage doubler **9,** the series circuit of the two diodes **D41** and **D42** is connected in parallel with the series circuit of the two capacitors **C31** and **C32**. In brief, the full-wave voltage doubler **9** includes a bridge circuit of the two diodes **D41** and **D42** and the two capacitors **C31** and **C32**.

The following explanation referring to **FIG. 4** is made to the operation of the energy harvesting device **1** in the first connection mode. **FIG. 4** does not show the controller **7.**

In the first connection mode, as shown in **FIG. 4****,** the piezoelectric vibration energy harvester **2** and the electric storage unit **3** are electrically connected to the first power extraction circuit **4,** and are electrically separated (electrically insulated) from the second power extraction circuit **5.**

The operation in a positive half cycle is described first. In the positive half cycle, one of the output ends (the first pad **25** of the electric generation portion **24**) of the piezoelectric vibration energy harvester **2** is higher in electric potential than the other of the output ends (the second pad **25** of the electric generation portion **24**).

The energy harvesting device **1** connects the series circuit of all the electric generation portions **24** of the piezoelectric vibration energy harvester **2** to the first power extraction circuit **4,** and the input terminal **441** of the first power extraction circuit **4** has an electric potential higher than an electric potential of the further input terminal **442** of the first power extraction circuit **4.** Thus, a current supplied from the piezoelectric vibration energy harvester **2,** flows through the diode **D41,** the capacitor **C31,** and the wire **43,** and returns to the piezoelectric vibration energy harvester **2**. Consequently, the capacitor **C31** is charged.

Next, the operation in a negative half cycle is described. In the negative half cycle, one of the output ends (the first pad **25** of the electric generation portion **24**) of the piezoelectric vibration energy harvester **2** is lower in electric potential than the other of the output ends (the second pad **25** of the electric generation portion **24**).

In the energy harvesting device **1,** the input terminal **441** of the first power extraction circuit **4** has an electric potential lower than an electric potential of the further input terminal **442** of the first power extraction circuit **4.** Thus, a current supplied from the piezoelectric vibration energy harvester **2,** flows through the wire **43,** the capacitor **C32,** and the diode **D42,** and returns to the piezoelectric vibration energy harvester **2.** Consequently, the capacitor **C32** is charged.

In short, the full-wave voltage doubler **9** charges the capacitor **C31** in one of the half cycles of the waveform of the output voltage of the piezoelectric vibration energy harvester **2,** and charges the other capacitor **C32** in the other of the half cycles. Thus, the voltage across the electric storage unit **3** (i.e., the output voltage of the energy harvesting device **1**) is about twice as high as the peak value of the output voltage of the piezoelectric vibration energy harvester **2**.

In the energy harvesting device **1,** the full-wave voltage doubler **9** is formed in the first connection mode. In contrast to a prior full-wave rectifier constituted by a bridge circuit of the four diodes **D1, D2, D3,** and **D4,** it is possible to reduce a voltage loss (forward voltage drop) caused by a circuit connected to an input side of the electric storage unit **3**. Hence, it is possible to downsize the energy harvesting device **1** and to increase the output of the energy harvesting device **1**.

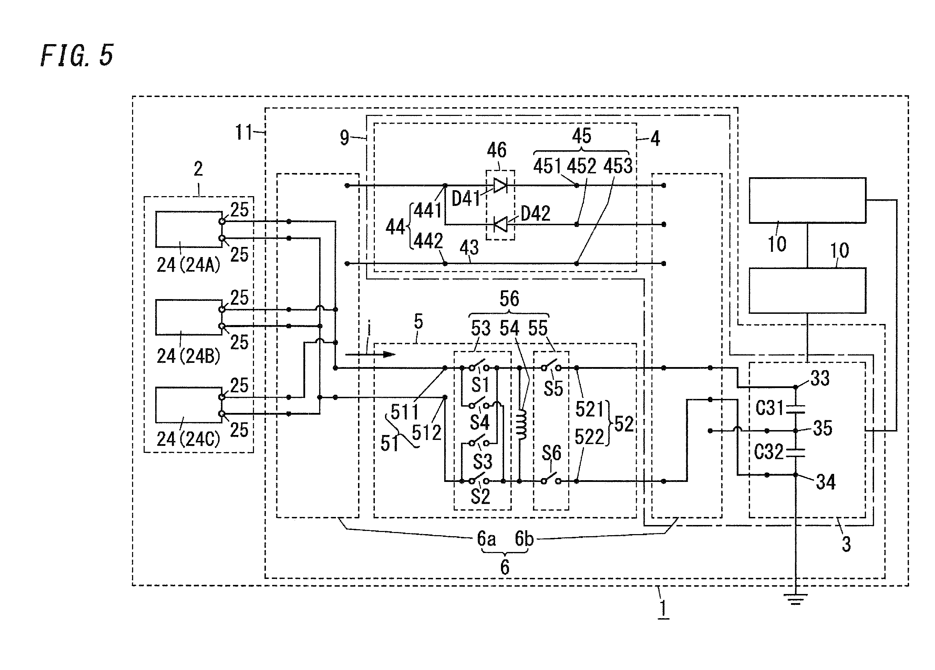

The following explanation referring to **FIGS. 5** to **8** is made to the operation of the energy harvesting device **1** in the second connection mode. **FIGS. 5** to **8** do not show the controller **7**.

In the second connection mode, as shown in **FIG. 5****,** the piezoelectric vibration energy harvester **2** and the electric storage unit **3** are electrically connected to the second power extraction circuit **5,** and are electrically separated (electrically insulated) from the first power extraction circuit **4.**

In this case, a parallel circuit of all the electric generation portions **24** (**24A, 24B,** and **24C**) of the piezoelectric vibration energy harvester **2** is connected between the pair of the input terminals **511** and **512** of the second power extraction circuit **5**.

Further, in the second connection mode, the first to sixth electronic analog switches **S1** to **S6** of the second power extraction circuit **5** are turned on and off by the controller **7** as described above.

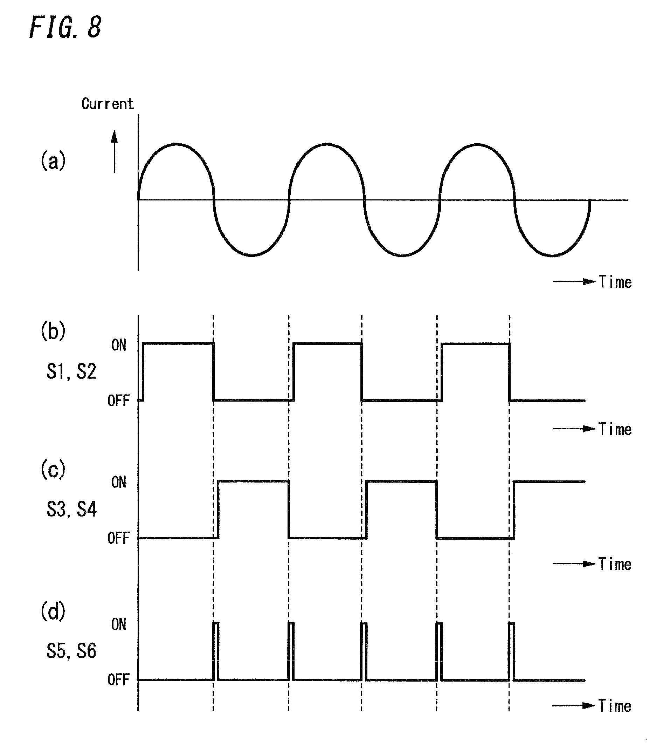

**FIG. 8(a)** shows a waveform of a current **"i"** (see **FIG. 5**) that flows from the piezoelectric vibration energy harvester **2** to the second power extraction circuit **5.** A direction of a flow of the current **"i"** from the piezoelectric vibration energy harvester **2** toward one input terminal **511** is treated as a positive direction. The waveform of the current **"i"** is sinusoidal, and the displacement measurement sensor **8** outputs a sine-wave AC signal substantially synchronized with the waveform of this current **"i"**.

**FIG. 8(b)** shows the ON and OFF states of the first and second electronic analog switches **S1** and **S2.** **FIG. 8(c)** shows the ON and OFF states of the third and fourth electronic analog switches **S3** and **S4.** **FIG. 8(d)** shows the ON and OFF states of the fifth and sixth electronic analog switches **S5** and **S6.**

The operation in the positive half cycle is described first. In the positive half cycle, one of the output ends (the first pad **25** of the electric generation portion **24**) of the piezoelectric vibration energy harvester **2** is higher in electric potential than the other of the output ends (the second pad **25** of the electric generation portion **24**).

In the energy harvesting device **1,** the input terminal **511** of the second power extraction circuit **5** has an electric potential higher than an electric potential of the further input terminal **512** of the second power extraction circuit **5.**

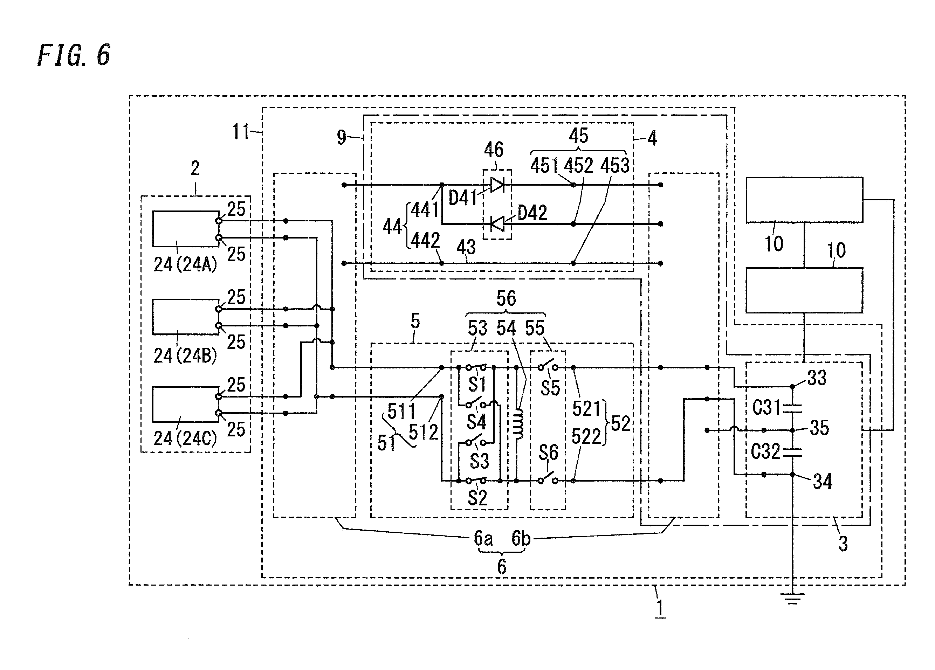

The controller **7** controls the second power extraction circuit **5** so as to turn on the first and second electronic analog switches **S1** and **S2** and turn off the third to sixth electronic analog switches **S3** to **S6** (**FIG. 6** shows an equivalent circuit of the second power extraction circuit **5** controlled by the controller **7** in this manner). Thus, the controller **7** performs the first storing operation.

The energy harvesting device **1** supplies the current **"i"** to the energy storage device **54** constituted by the inductor, and therefore energy is stored in the energy storage device **54.**

Next, the operation in the negative half cycle is described. In the negative half cycle, one of the output ends (the first pad **25** of the electric generation portion **24**) of the piezoelectric vibration energy harvester **2** is lower in electric potential than the other of the output ends (the second pad **25** of the electric generation portion **24**).

The controller **7** functions to detect the zero crossing of the AC signal from the displacement measurement sensor **8.** First, the controller **7** controls the second power extraction circuit **5** so as to, in synchronization with the zero crossing of the AC signal from the displacement measurement sensor **8,** turn on the fifth and sixth electronic analog switches **S5** and **S6** and turn off the first to fourth electronic analog switches **S1** to **S4.** Thus, the controller **7** performs the discharging operation.

Accordingly, the energy harvesting device **1** discharges energy stored in the energy storage device **54** and charges the electric storage unit **3** with this discharged energy.

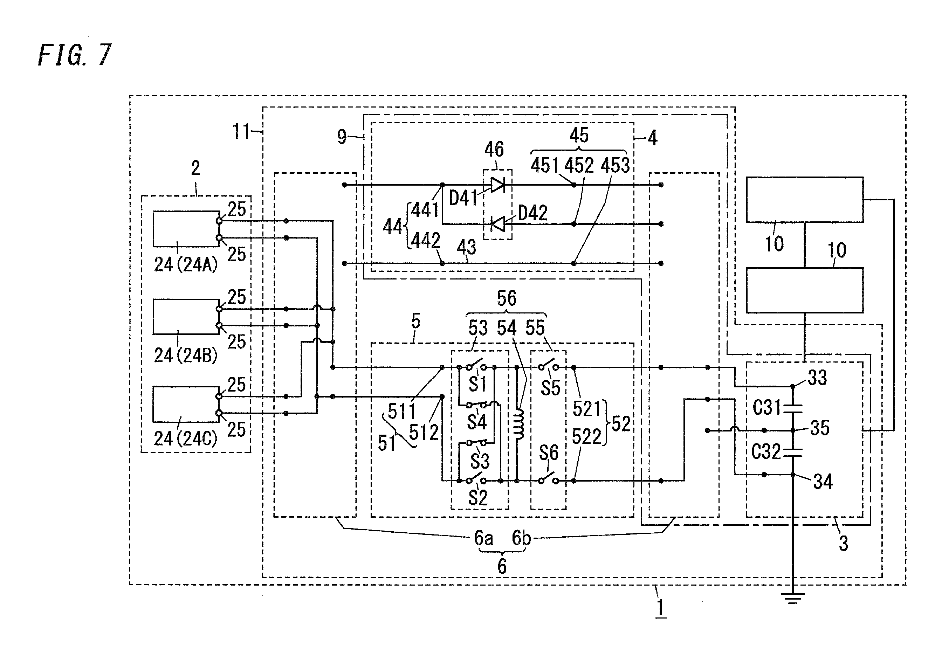

Thereafter, the controller **7** controls the second power extraction circuit **5** so as to turn on the third and fourth electronic analog switches **S3** and **S4** and turn off the first, second, fifth and sixth electronic analog switches **S1, S2, S5,** and **S6** (**FIG. 7** shows an equivalent circuit of the second power extraction circuit **5** controlled by the controller **7** in this manner). Thus, the controller **7** performs the second storing operation.

The energy harvesting device **1** supplies the current **"i"** to the energy storage device **54** constituted by the inductor, and therefore energy is stored in the energy storage device **54.**

Thereafter, when, in the positive half cycle, one of the output ends (the first pad **25** of the electric generation portion **24**) of the piezoelectric vibration energy harvester **2** is higher in electric potential than the other of the output ends (the second pad **25** of the electric generation portion **24**), the controller **7** controls the second power extraction circuit **5** so as to, in synchronization with the zero crossing of the AC signal from the displacement measurement sensor **8,** turn on the fifth and sixth electronic analog switches **S5** and **S6** and turn off the first to fourth electronic analog switches **S1** to **S4**. Thus, the controller **7** performs the discharging operation.

Accordingly, the energy harvesting device **1** discharges energy stored in the energy storage device **54** and charges the electric storage unit **3** with this discharged energy.

Subsequently, as described above, the controller **7** controls the second power extraction circuit **5** so as to turn on the first and second electronic analog switches **S1** and **S2** and turn off the third to sixth electronic analog switches **S3** to **S6** (**FIG**. **6** shows an equivalent circuit of the second power extraction circuit **5** controlled by the controller **7** in this manner). Thus, the controller **7** performs the first storing operation again.

The second power extraction circuit **5** repeats storing energy in the aforementioned energy storage device **54** and discharging energy from the energy storage device **54.** In short, the controller **7** performs the storing operation and the discharging operation alternately.

The energy harvesting device **1** of the present embodiment described above includes the piezoelectric vibration energy harvester **2,** the first power extraction circuit **4,** and the second power extraction circuit **5.** The piezoelectric vibration energy harvester **2** includes two or more electric generation portions **24.** The first power extraction circuit **4** is constituted by the two diodes **D41** and **D42.** The second power extraction circuit **5** is constituted by the electronic analog switches **S1** to **S6** and the energy storage device **54.** Further, the energy harvesting device **1** includes the switch circuit **6** and the controller **7.** The switch circuit **6** is configured to switch between the first connection mode and the second connection mode selectively. The controller **7** is configured to operate on electricity from the electric storage unit **3** and to control the second power extraction circuit **5** and the switch circuit **6.** The switch circuit **6** is configured to, in the first connection mode, connect the series circuit of the two or more electric generation portions **24** between the input terminals of the first power extraction circuit **4** and connect the electric storage unit **3** between the output terminals of the first power extraction circuit **4.** The switch circuit **6** is configured to, in the second connection mode, connect the parallel circuit of the two or more electric generation portions **24** between the input terminals of the second power extraction circuit **5** and connect the electric storage unit **3** between the output terminals of the second power extraction circuit **5.**

In other words, the energy harvesting device of the present embodiment includes: the electric generator (piezoelectric vibration energy harvester) **2** for charging the electric storage (electric storage unit) **3**; and the power management circuit **11** configured to operate with power from the electric storage **3,** and to charge the electric storage **3** with power from the electric generator **2.** The electric generator **2** includes the two or more electric generation portions **24** each configured to generate AC power when vibrated. The power management circuit **11** includes the first power extraction circuit **4,** the second power extraction circuit **5,** and the switch circuit **6.** The first power extraction circuit **4** includes the first input unit **44,** the first output unit **45,** and the rectification circuit **46** between the first input unit **44** and the first output unit **45.** The rectification circuit **46** is configured to convert AC power received by the first input unit **44** into DC power and provide the converted DC power to the first output unit **45.** The second power extraction circuit **5** includes the second input unit **51,** the second output unit **52,** and the switching circuit **56.** The switching circuit **56** is between the second input unit **51** and the second output unit **52** and is configured to operate with power supplied from the electric storage **3.** The switching circuit **56** is configured to generate DC power by use of AC power received by the second input unit **51** and provide the generated DC power to the second output unit **52.** The switch circuit **6** has the first connection mode of connecting the electric generator **2** and the electric storage **3** to the first input unit **44** and the first output unit **45,** respectively, and the second connection mode of connecting the electric generator **2** and the electric storage **3** to the second input unit **51** and the second output unit **52,** respectively. The switch circuit **6** is configured to, in the first connection mode, connect the two or more electric generation portions **24** to the first input unit **44** such that the effective value of the AC voltage to be provided to the first input unit **44** in the first connection mode is greater than the effective value of the AC voltage to be provided to the second input unit **51** in the second connection mode. The switch circuit **6** is configured to, in the second connection mode, connect the two or more electric generation portions **24** to the second input unit **51** such that the effective value of the AC voltage to be provided to the second input unit **51** in the second connection mode is greater than the effective value of the AC voltage to be provided to the first input unit **44** in the first connection mode.

Further, the switch circuit **6** of the energy harvesting device **1** is configured to, in the first connection mode, make the series circuit of the two or more electric generation portions **24** and connect the series circuit to the first input unit **44,** and is configured to, in the second connection mode, make the parallel circuit of the two or more electric generation portions **24** and connect the parallel circuit to the second input unit **51.** Note that, this configuration is optional.

The energy harvesting device **1** further includes the electric storage **3**. Note that, this configuration is optional.

Accordingly, in the energy harvesting device **1** of the present embodiment, the controller **7** controls the switch circuit **6.** It is possible to charge the electric storage unit 3 efficiently. In short, the energy harvesting device **1** of the present embodiment can charge the electric storage unit **3** efficiently.

In this energy harvesting device **1,** it is preferable that, when the output voltage of the electric storage unit **3** is higher than the minimum operating voltages of the controller **7** and the second power extraction circuit **5,** the controller **7** switch the switch circuit **6** to the second connection mode.

In other words, in the energy harvesting device **1,** the power management circuit **11** includes the controller **7** configured to operate with power from the electric storage **3.** The controller **7** is configured to, when the output voltage of the electric storage **3** is not less than the predetermined voltage, switch the switch circuit **6** from the first connection mode to the second connection mode. Note that, this configuration is optional.

In this energy harvesting device **1,** the predetermined voltage is the minimum operating voltage of the power management circuit **11.** Note that, this configuration is optional.

In this energy harvesting device **1,** the minimum operating voltage of the power management circuit **11** is not less than the minimum operating voltage of the second power extraction circuit **5** and also is not less than the minimum operating voltage of the controller **7.** Note that, this configuration is optional.

Accordingly, the energy harvesting device **1** can efficiently extract generation power from the piezoelectric vibration energy harvester **2** and charge the electric storage unit 3 with the extracted generation power. Note that, the minimum operating voltages of the controller **7** and the second power extraction circuit **5** may be different voltages or the same voltage.

In this energy harvesting device **1,** it is preferable that the switch circuit **6** includes the aforementioned first to fourth switch devices **Q1** to **Q4** and each of the first switch device **Q1** and the second switch device **Q2** is a normally-on switch and each of the third switch device **Q3** and the fourth switch device **Q4** is a normally-off switch. In this case, the first switch device **Q1** is interposed between the piezoelectric vibration energy harvester **2** and the first power extraction circuit **4.** The second switch device **Q2** is interposed between the first power extraction circuit **4** and the electric storage unit **3**. The third switch device **Q3** is interposed between the piezoelectric vibration energy harvester **2** and the second power extraction circuit **5.** The fourth switch device **Q4** is interposed between the piezoelectric vibration energy harvester **2** and the electric storage unit **3**.

In other words, the switch circuit **6** is configured to be in the first connection mode while the output voltage of the electric storage is less than the predetermined voltage. Note that, this configuration is optional.

Especially, the switch circuit **6** includes: the first switch device **Q1** between the electric generator **2** and the first input unit **44;** the second switch device **Q2** between the electric storage **3** and the first output unit **45;** the third switch device **Q3** between the electric generator **2** and the second input unit **51;** and the fourth switch device **Q4** between the electric storage **3** and the second output unit **52.** Each of the first switch device **Q1** and the second switch device **Q2** is a normally-on switch. Each of the third switch device **Q3** and the fourth switch device **Q4** is a normally-off switch. Note that, this configuration is optional.

Accordingly, when the output voltage of the electric storage unit **3** is less than the minimum operating voltages of the controller **7** and the second power extraction circuit **5,** the energy harvesting device **1** connects the piezoelectric vibration energy harvester **2** to the first power extraction circuit **4.** Thus, the energy harvesting device **1** can extract the generation power from the piezoelectric vibration energy harvester **2** and charge the electric storage unit **3** with the extracted generation power. In short, even when the output voltage of the electric storage unit **3** is 0 V or is less than the minimum operating voltages temporarily, the energy harvesting device **1** can extract the generation power from the piezoelectric vibration energy harvester **2** by use of the first power extraction circuit **4** and charge the electric storage unit **3** with the extracted generation power.

In the energy harvesting device **1,** the electric storage unit **3** is constituted by the series circuit of the two capacitors **C31** and **C32.** The first power extraction circuit **4** is constituted by the series circuit of the two diodes **D41** and **D42.** In the first connection mode, the connection point of the two diodes **D41** and **D42** is connected to the output end of the piezoelectric vibration energy harvester **2** (the first pad **25** of the electric generation portion **24**) and the connection point of the two capacitors **C31** and **C32** is connected to the further output end of the piezoelectric vibration energy harvester **2** (the second pad **25** of the electric generation portion **24**). Thereby, the full-wave voltage doubler **9** configured to voltage doubler rectification on the AC voltage generated by the piezoelectric vibration energy harvester **2** is formed.

In other words, in the energy harvesting device **1**, the electric storage **3** includes the first capacitive element (capacitor **C31**) and the second capacitive element (capacitor **C32**). The rectification circuit **46** includes the first rectifying element (diode **D41**) and the second rectifying element (diode **D42**). The first input unit **44** includes the first input terminal **441** and the second input terminal **442**. The first output unit **45** includes the first output terminal **451,** the second output terminal **452,** and the third output terminal **453.** The anode of the first rectifying element (diode **D41**) and the cathode of the second rectifying element (diode **D42**) are connected to the first input terminal **441.** The cathode of the first rectifying element (diode **D41**) is connected to the first output terminal **451**. The anode of the second rectifying element (diode **D42**) is connected to the second output terminal **452.** The second input terminal **442** is connected to the third output terminal **453.** The switch circuit **6** is configured to, in the first connection mode, connect the two or more electric generation portions **24** in series between the first input terminal **441** and the second input terminal **442**, connect the first capacitive element (capacitor **C31**) and the second capacitive element (capacitor **C32**) in series between the first output terminal **451** and the second output terminal **452,** and connect the third output terminal **453** to the connection point (ground terminal) **35** of the first capacitive element (capacitor **C31**) and the second capacitive element (capacitor **C32**). Note that, this configuration is optional.

Accordingly, the energy harvesting device **1** can increase the voltage of the electric storage unit 3 in the first connection mode. Note that, the energy harvesting device **1** may form a circuit different from the full-wave voltage doubler **9** in the first connection mode.

In a preferred embodiment of the energy harvesting device **1**, as described above, the piezoelectric vibration energy harvester **2** includes the supporting portion **21** and the movable portion **22**. The movable portion **22** is swingably supported by the supporting portion **21**, and vibrates in response to an environmental vibration. The two or more electric generation portions **24** are on the movable portion **22**.

In the energy harvesting device **1,** the two or more electric generation portions **24** are provided to the same movable portion in the piezoelectric vibration energy harvester **2** of the single chip. It is possible to avoid an unwanted situation where the outputs of the electric generation portions **24** have different amplitudes and different phases. According to the energy harvesting device **1**, it is possible to downsize the piezoelectric vibration energy harvester **2** and increase the output of the piezoelectric vibration energy harvester **2,** in contrast to an instance where the two or more electric generation portions **24** are on different chips.

In a preferred embodiment of the energy harvesting device **1,** the energy harvesting device **1 further** includes the displacement measurement sensor **8.** The displacement measurement sensor **8** is configured to determine the displacement of the movable portion **22.** The controller **7** turns on and off the electronic analog switches **S1** to **S6** of the second power extraction circuit **5** at near the zero crossing of the AC signal from the displacement measurement sensor **8.**

Accordingly, the controller **7** of the energy harvesting device **1** can indirectly and accurately detect the zero crossing of the AC current caused by the AC voltage generated by the piezoelectric vibration energy harvester **2,** based on the AC signal outputted from the displacement measurement sensor **8.** Hence, the energy harvesting device **1** can efficiently extract the generation power from the piezoelectric vibration energy harvester **2** in the second connection mode. Therefore, the energy harvesting device **1** can efficiently charge the electric storage unit **3.**

In other words, the second power extraction circuit **5** of the energy harvesting device **1** includes: the energy storage device **54;**
the first switch unit **53** between the second input unit **51** and the energy storage device **54,** the second switch unit **55** between the second output unit **52** and the energy storage device **54,** and the control circuit (controller **7**). The control circuit (controller **7**) is configured to operate with power from the electric storage **3,** and configured to control the first switch unit **53** and the second switch unit **55** to convert the AC voltage received by the second input unit **51** to the DC voltage and provide the converted DC voltage to the second output unit **52.** Note that, this configuration is optional.

In particular, the control circuit (controller **7**) of the energy harvesting device **1** is configured to, while the AC voltage to be provided to the second input unit **51** has the positive or negative polarity, perform the storing operation in which the control circuit (controller **7**) keeps turning off the second switch unit **55** and controls the first switch unit **53** so as to store energy in the energy storage device **54**. The control circuit (controller **7**) is configured to, when the AC voltage to be provided to the second input unit **51** becomes zero, start the discharging operation in which the control circuit (controller **7**) turns off the first switch unit **53** and turns on the second switch unit **55** so as to allow the energy storage device **54** to provide the DC voltage to the second output unit **52**. Note that, this configuration is optional.

Especially, in the energy harvesting device **1**, the second input unit **51** includes the third input terminal **511** and the fourth input terminal **512.** The second output unit **52** includes the fourth output terminal **521** and the fifth output terminal **522.** The first switch unit **53** includes the first switch **S1** between the first end of the energy storage device **54** and the third input terminal **511,** the second switch **S2** between the second end of the energy storage device **54** and the fourth input terminal **512,** the third switch **S3** between the first end of the energy storage device **54** and the fourth input terminal **512,** and the fourth switch **S4** between the second end of the energy storage device **54** and the third input terminal **511.** The second switch unit **55** includes the fifth switch **S5** between the first end of the energy storage device **54** and the fourth output terminal **521,** and the sixth switch **S6** between the second end of the energy storage device **54** and the fifth output terminal **522**. The switch circuit **6** is configured to, in the second connection mode, connect the two or more electric generation portions **24** in parallel between the third input terminal **511** and the fourth input terminal **512** and connect the electric storage **3** between the fourth output terminal **521** and the fifth output terminal **522**. The control circuit (controller **7**) is configured to: while the AC voltage to be provided to the second input unit **51** has one of the positive polarity and the negative polarity, turn on the first switch **S1** and the second switch **S2** and turn off the third switch **S3** and the fourth switch **S4** while turning off the fifth switch **S5** and the sixth switch **S6,** so as to perform the storing operation; and while the AC voltage to be provided to the second input unit **51** has the other of the positive polarity and the negative polarity, turn off the first switch **S1** and the second switch **S2** and turn on the third switch **S3** and the fourth switch **S4** while turning off the fifth switch **S5** and the sixth switch **S6**, so as to perform the storing operation. The control circuit (controller **7**) is configured to, when the AC voltage to be provided to the second input unit **51** becomes zero, turn off the first switch **S1**, the second switch **S2**, the third switch **S3**, and the fourth switch **S4** and turn on the fifth switch **S5** and the sixth switch **S6**, so as to perform the discharging operation. Note that, this configuration is optional.

Specifically, the energy harvesting device 1 further includes the displacement measurement sensor **8**. The electric generator **2** includes the movable portion **22** which is movable from the basic position in response to a vibration given to the movable portion **22**. The two or more electric generation portions **24** are provided to the movable portion **22,** and each configured to generate AC power depending on the displacement of the movable portion **22** from the basic position. The displacement measurement sensor **8** is configured to measure the displacement of the movable portion **22** from the basic position. The control circuit (controller **7**) is configured to, when the displacement of the movable portion **22** from the basic position measured by the displacement measurement sensor **8** becomes zero, start the discharging operation. Not that, this configuration is optional.

Notably, the displacement measurement sensor **8** of the energy harvesting device **1** is a capacitance displacement measurement sensor. Note that, this configuration is optional.

Besides, the controller **7** may turn on and off the electronic analog switches **S1** to **S6** of the second power extraction circuit **5** depending on an output from a sensor (e.g., a current transformer) configured to detect a current flowing through the second power extraction circuit **5,** as an alternative to the AC signal outputted from the displacement measurement sensor **8.**

In short, the energy harvesting device 1 further includes a current measurement device (e.g., a current transformer). The current measurement device is configured to measure an alternating current supplied to the second input unit **51**. The control circuit (controller **7**) is configured to, when the current measured by the current measurement device becomes zero, start the discharging operation.

### (SECOND EMBODIMENT)

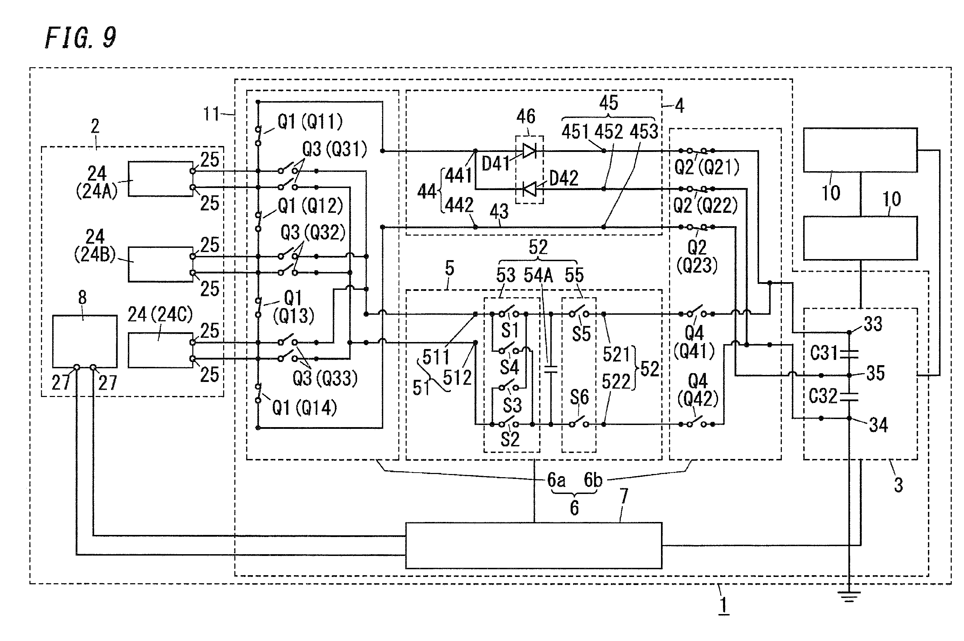

Hereinafter, the energy harvesting device **1** of the present embodiment is described with reference to **FIG. 9****.**

The energy harvesting device **1** of the present embodiment has substantially the same basic configuration as that of the first embodiment. However, the energy harvesting device **1** of the present embodiment is different from the first embodiment in a circuit configuration of the second power extraction circuit **5**. Besides, components common to the present embodiment and the first embodiment are designated by the same reference numerals and explanations thereof are deemed unnecessary.

The second power extraction circuit **5** of the energy harvesting device **1** of the first embodiment includes the energy storage device **54** constituted by the inductor. Whereas, the second power extraction circuit **5** of the energy harvesting device 1 of the present embodiment includes the energy storage device **54** (**54A**) constituted by a capacitor. The energy storage device **54A** may be constituted by one or more capacitors.

Besides, the second power extraction circuit **5** operates in the same manner as that of the first embodiment.

Like the first embodiment, the switch circuit **6** is controlled by the controller 7 in the energy harvesting device **1** of the present embodiment. Hence, it is possible to charge the electric storage unit **3** efficiently.

Note that, the circuit configurations of the second power extraction circuits **5** described in the first and second embodiments are merely examples, and are not limited particularly. However, the second power extraction circuit **5** may have another configuration.

## Claims

1. An energy harvesting device, comprising:
an electric generator for charging an electric storage; and
an power management circuit configured to operate with power from the electric storage, and to charge the electric storage with power from the electric generator,
the electric generator including two or more electric generation portions each configured to generate AC power when vibrated,
the power management circuit including
a first power extraction circuit,
a second power extraction circuit, and
a switch circuit,
the first power extraction circuit including a first input unit, a first output unit, and a rectification circuit between the first input unit and the first output unit,
the rectification circuit being configured to convert AC power received by the first input unit into DC power and provide the converted DC power to the first output unit,
the second power extraction circuit including a second input unit, a second output unit, and a switching circuit which is between the second input unit and the second output unit and is configured to operate with power supplied from the electric storage,
the switching circuit being configured to generate DC power by use of AC power received by the second input unit and provide the generated DC power to the second output unit,
the switch circuit having a first connection mode of connecting the electric generator and the electric storage to the first input unit and the first output unit, respectively, and a second connection mode of connecting the electric generator and the electric storage to the second input unit and the second output unit, respectively,
the switch circuit being configured to, in the first connection mode, connect the two or more electric generation portions to the first input unit such that an effective value of an AC voltage to be provided to the first input unit in the first connection mode is greater than an effective value of an AC voltage to be provided to the second input unit in the second connection mode, and
the switch circuit being configured to, in the second connection mode, connect the two or more electric generation portions to the second input unit such that the effective value of the AC voltage to be provided to the second input unit in the second connection mode is greater than the effective value of the AC voltage to be provided to the first input unit in the first connection mode.

2. The energy harvesting device according to claim 1, wherein
the switch circuit is configured to, in the first connection mode, make a series circuit of the two or more electric generation portions and connect the series circuit to the first input unit, and is configured to, in the second connection mode, make a parallel circuit of the two or more electric generation portions and connect the parallel circuit to the second input unit.

3. The energy harvesting device according to claim 1, wherein:
the power management circuit includes a controller configured to operate with power from the electric storage: and
the controller is configured to, when an output voltage of the electric storage is not less than a predetermined voltage, switch the switch circuit from the first connection mode to the second connection mode.

4. The energy harvesting device according to claim 3, wherein
the predetermined voltage is a minimum operating voltage of the power management circuit.

5. The energy harvesting device according to claim 4, wherein
the minimum operating voltage of the power management circuit is not less than a minimum operating voltage of the second power extraction circuit and also is not less than a minimum operating voltage of the controller.

6. The energy harvesting device according to claim 1, wherein
the switch circuit is configured to be in the first connection mode while an output voltage of the electric storage is less than a predetermined voltage.

7. The energy harvesting device according to claim 1, wherein:
the switch circuit includes
a first switch device between the electric generator and the first input unit,
a second switch device between the electric storage and the first output unit,
a third switch device between the electric generator and the second input unit, and
a fourth switch device between the electric storage and the second output unit,
each of the first switch device and the second switch device is a normally-on switch, and
each of the third switch device and the fourth switch device is a normally-off switch.

8. The energy harvesting device according to claim 1, further comprising the electric storage.

9. The energy harvesting device according to claim 8, wherein:
the electric storage includes a first capacitive element and a second capacitive element;
the rectification circuit includes a first rectifying element and a second rectifying element;
the first input unit includes a first input terminal and a second input terminal;
the first output unit includes a first output terminal, a second output terminal, and a third output terminal;
an anode of the first rectifying element and a cathode of the second rectifying element are connected to the first input terminal,
a cathode of the first rectifying element is connected to the first output terminal,
an anode of the second rectifying element is connected to the second output terminal,
the second input terminal is connected to the third output terminal, and
the switch circuit is configured to, in the first connection mode, connect the two or more electric generation portions in series between the first input terminal and the second input terminal, connect the first capacitive element and the second capacitive element in series between the first output terminal and the second output terminal, and connect the third output terminal to a connection point of the first capacitive element and the second capacitive element.

10. The energy harvesting device according to claim 1, wherein
the switching circuit includes
an energy storage device,
a first switch unit between the second input unit and the energy storage device,
a second switch unit between the second output unit and the energy storage device, and
a control circuit configured to operate with power from the electric storage, and configured to control the first switch unit and the second switch unit to convert an AC voltage received by the second input unit to a DC voltage and provide the converted DC voltage to the second output unit.

11. The energy harvesting device according to claim 10, wherein:
the control circuit is configured to, while an AC voltage to be provided to the second input unit has a positive or negative polarity, perform a storing operation in which the control circuit keeps turning off the second switch unit and controls the first switch unit so as to store energy in the energy storage device; and
the control circuit is configured to, when an AC voltage to be provided to the second input unit becomes zero, start a discharging operation in which the control circuit turns off the first switch unit and turns on the second switch unit so as to allow the energy storage device to provide a DC voltage to the second output unit.

12. The energy harvesting device according to claim 10, wherein:
the second input unit includes a third input terminal and a fourth input terminal;
the second output unit includes a fourth output terminal, and a fifth output terminal;
the first switch unit includes a first switch between a first end of the energy storage device and the third input terminal, a second switch between a second end of the energy storage device and the fourth input terminal, a third switch between the first end of the energy storage device and the fourth input terminal, and a fourth switch between the second end of the energy storage device and the third input terminal,
the second switch unit includes a fifth switch between the first end of the energy storage device and the fourth output terminal, and a sixth switch between the second end of the energy storage device and the fifth output terminal,
the switch circuit is configured to, in the second connection mode, connect the two or more electric generation portions in parallel between the third input terminal and the fourth input terminal and connect the electric storage between the fourth output terminal and the fifth output terminal,
the control circuit is configured to,
while an AC voltage to be provided to the second input unit has one of a positive polarity and a negative polarity, turn on the first switch and the second switch and turn off the third switch and the fourth switch while turning off the fifth switch and the sixth switch, so as to perform the storing operation,
while an AC voltage to be provided to the second input unit has the other of the positive polarity and the negative polarity, turn off the first switch and the second switch and turn on the third switch and the fourth switch while turning off the fifth switch and the sixth switch, so as to perform the storing operation, and
when an AC voltage to be provided to the second input unit becomes zero, turn off the first switch, the second switch, the third switch, and the fourth switch and turn on the fifth switch and the sixth switch, so as to perform the discharging operation.

13. The energy harvesting device according to claim 11, wherein:
the energy harvesting device further comprises a displacement measurement sensor;
the electric generator includes a movable portion which is movable from a basic position in response to a vibration given thereto;
the two or more electric generation portions are provided to the movable portion, and each configured to generate AC power depending on a displacement of the movable portion from the basic position;
the displacement measurement sensor is configured to measure the displacement of the movable portion from the basic position; and
the control circuit is configured to, when the displacement of the movable portion from the basic position measured by the displacement measurement sensor becomes zero, start the discharging operation.

14. The energy harvesting device according to claim 13, wherein
the displacement measurement sensor is a capacitance displacement measurement sensor.

15. The energy harvesting device according to claim 11, wherein:
the energy harvesting device further comprises a current measurement device;
the current measurement device is configured to measure an alternating current supplied to the second input unit; and
the control circuit is configured to, when the current measured by the current measurement device becomes zero, start the discharging operation.
